# EUROPEAN PATENT APPLICATION

(11) **EP 3 229 359 A1**
(43) Date of publication of application: **11.10.2017**
(21) Application number: 16164031.3
(22) Date of filing: 06.04.2016
(51) Int. Cl.: H02M 3/335, H02M 7/48

(54) **RESONANT CONVERTER AND POWER DEVICE WITH SUCH A CONVERTER**

(71) Applicant: Neumüller Elektronik GmbH, 91085 Weisendorf (DE); Fischer, Uwe, 91085 Weisendorf (DE)
(72) Inventor: Bondar, Henri, 90502 Flic en Flac (MU)
(74) Representative: Kruspig, Volkmar

(57) **Abstract**

The invention relates to a converter (10), especially for use at high voltage ratios, characterized by a cascade of at least two steps, wherein at least the first step is made of a resonant unit (15), which comprises at least one inductive reactance unit and at least one capacitor unit, which are connected in series.

## Description

The invention relates to a converter, especially for use at high voltage ratios, according to claim 1. Furthermore, the invention relates to a power device with such a converter, according to claim 13.

The present invention relates to the area of electrical current conversion. The converter according to the invention and the power device according to the invention are particularly preferred in connection with the voltage rise or voltage drop associated with DC-AC converters or DC-DC converters, Primarily, the converter according to the invention and the power device according to the invention are used at large voltage ratios.

Step-down converters and step-up converters, which are based on a single coil, are known for example as buck converters or boost converters. Such converters are very practical, since the coil can be connected to a single switch, which is preferably constituted semiconductor-based. It is possible that the switch is optionally connected to an external diode. In addition, the output voltage can be controlled in a straightforward manner with the aid of a pulse width modulation (PWM) technique. Such converters can be constituted in such a way that they can operate at relatively large frequencies.

For reasons of efficiency, however, these converters are limited to relatively small voltage ratios. With larger voltage ratios, especially with voltage ratios above ten, use is usually made of transformers. Use may be made both of inductive as well as piezoelectric transformers. With the aid of transformer technology, the working frequency is usually intended to be increased so that the power capability can be increased with the same size or the size of the device can be reduced with the same power capability. However, the maximum frequency for piezoelectric structures is limited by the size of the device. The frequency in the case of inductive transformers is limited on account of the ferrite core material.

At higher frequencies, both technologies, both piezoelectric transformers and inductive transformers, exhibit stray capacitance effects. Most piezoelectric transformer structures are resonant. This resonance can be used to increase the voltage ratios and to reduce the switching losses. In the case of piezoelectric transformers, the voltage ratio can be improved by the adaptation of the aspect ratio or by multi-layer structures. In the case of inductive transformers, the voltage ratio is essentially controlled by the turns ratio.

Many techniques have been developed in the past in connection with inductive transformers in order to increase their frequency range. In order to reduce the so-called skin effect, use may be made for example of litz wires. Layered or segmented windings can be formed to reduce stray capacitance effects. However, it is extremely difficult to design inductive transformers and power coils in a compact manner at frequencies of over 1 MHz, since both the litz technique and the usual core materials do not behave suitably at frequencies over 1 MHz.

It is also known, in the case of circuits comprising coils or transformers, to use the resonance in order to provide *zero current switching* (ZCS) or *zero voltage switching* (ZVS) conditions. These ZCS or ZVS conditions enable a drastic reduction in switching losses. This offers the possibility of using switching modes which are based on existing MOSFET technologies. This can take place especially at frequencies of up to 100 MHz.

In order to reduce switching losses at high frequencies, quasi-resonant structures have recently been developed. Such structures have to be operated close to the resonance frequency in order to achieve ZCS or ZVS conditions. At higher frequencies, however, it is no longer possible to use PWM techniques to maintain ZCS conditions. Such converters, which are working in permanent oscillating regimes, are usually referred to as fully resonant converters.

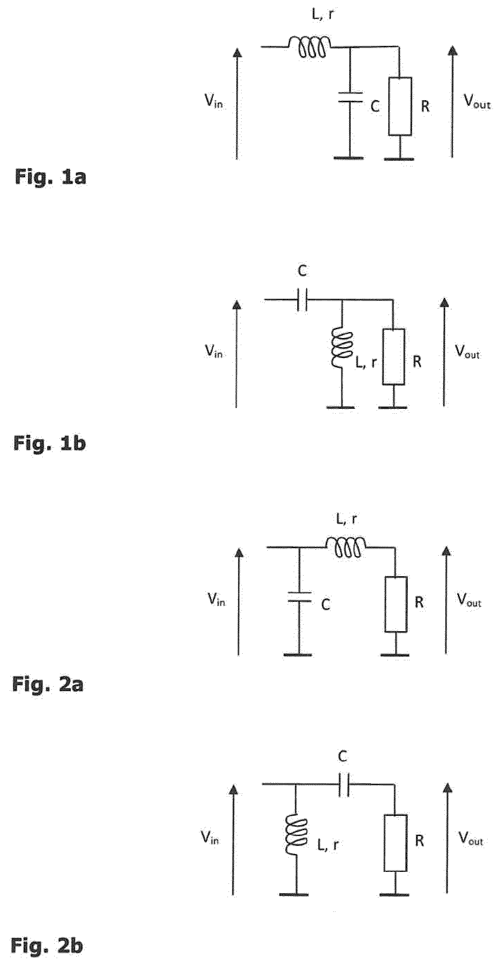

Figures 1a and 1b and figures 2a and 2b represent resonant structures which comprise a single coil. Figures 1a and 1b represent step-up conversions and figures 2a and 2b represent step-down conversions. If the resonant structures are made with ideal components, the input impedance is resistive with respect to a single frequency, the so-called resonance frequency. In the case of actual implementations, this frequency may differ slightly from the frequency that is associated with the maximum voltage or minimum voltage of the step-up converter or step-down converter.

The differences between the various circuits of figures 1a to 2b are crucial with regard to the harmonic behaviour. A step-up converter (Fig. 1a and Fig. 1b) can be driven by means of a square wave signal, since the input impedance is minimised only at resonance frequency. In the circuit according to Fig. 1a the high-frequency impedance is very great, whereas for the circuit represented in Fig. 1b the high-frequency impedance is limited to load impedance R. Accordingly, harmonics are suppressed more effectively in connection with the circuit represented in Fig 1a than in the circuit represented in Fig. 1b.

An operation with square wave signals is scarcely possible in connection with the step-down oscillatory circuits or step-down converters represented in Fig. 2a and Fig. 2b, since the input impedance at resonance frequency is somewhat higher than for high-frequency harmonics. Especially in the example represented in Fig. 2a, the high-frequency impedance tends towards zero.

The main difficulty in connection with the resonance circuits consists in regulating the load in the case of variable load conditions. The step-down or step-up voltage ratios depend directly on the value of the equivalent load resistance. For small voltage ratios, the voltage amplification is proportional to the load factor a = RCω. For example, the voltage ratio with a step-up converter is roughly doubled when the load resistance is doubled. Electronic control circuits are always required with such converters.

Known electronic control means are for example input voltage control, pulse width modulation, SOPS (self-oscillating power supply) or burst mode control.

Reference is made for example to US 8,107,263 B2 and US 7,986,535 B2 or US 8,339,813 B2. Converters are disclosed in these publications which comprise transformers for the voltage conversion. A high-frequency module in connection with a broadcasting application is disclosed in US 7,388,435 B2.

Use has hitherto been made of transformers to achieve large voltage ratios. Such transformers are usually extremely bulky and easily destructible. Moreover, these transformers are limited to intermediate frequency ranges on account of the large dimensions of the transformer core. The large dimensions of the transformer core are moreover associated with large stray capacitances.

Proceeding from the aforesaid, therefore, it is the problem of the invention to raise the frequency domain with the aid of a newly designed converter in order to correspondingly increase the power density. Moreover, a converter is to be made available, which is constituted very thin, extremely robust and optionally very flexible. The converter should preferably have the dimensions of a credit card or be constituted as an extremely thin portable device. Transformers are to be dispensed with in connection with a further-developed converter.

The solution to the problem takes place on the one hand by means of a converter, especially for use at high voltage ratios, according to claim 1. Furthermore, the problem is solved by a power device according to claim 13.

According to the invention, the converter comprises at least one resonant unit, which comprises at least one inductive reactance unit and at least one capacitor connected in series.

Preferably, one step of a two-step converter is formed by a mentioned resonant unit. The resonant unit comprises at least on inductive reactance unit and at least one capacitor unit connected in series. One terminal side is connected to a common ground.

In order to reduce the thickness or in order to increase the ruggedness, the resonant unit particularly preferably comprises several inductive resonance units and/or several capacitor units, which are connected in series and/or in parallel.

Furthermore, the converter can comprise at least two resonant units which are connected in cascades, wherein each resonant unit comprises at least one inductive reactance unit and at least one capacitor unit.

A high-level port of an elementary resonant unit is formed between a conductor and the common ground, wherein the conductor links the inductive reactance unit and the capacitor unit of the resonant unit. A low-level port is formed between the remaining open side of the elementary resonant unit and the ground.

The at least two resonant units are connected in cascade through their input ports and output ports. Therefore, successive up and down conversion steps are formed.

Two ports of an assembly of at least two resonant units are connected on one side to a signal generator and on the other side to a load circuit or a rectification circuit or a voltage multiplier. If the high-level port is connected to the signal generator, a down converter will be obtained. If the low-level port is connected to the signal generator, an up-converter will be obtained.

In other words: The assembly of at least two resonant units is terminated on one side by a power consuming circuit and on the other side by an alternating current generator circuit.

Furthermore, the resonant units are formed in such a manner, that the inductive reactance units and the capacitor units of a resonant unit have reactance values very close or equal in amplitude and opposed in signs.

The inductive reactance units and the capacitor units of the at least two resonant units are preferably built of identical components, which are arranged in parallel and/or in series.

The formation of the converter according to the invention is based on several general considerations:

The invention is based on replacing the bulky and fragile transformers limited with respect to the frequency by a solution which is based on the use of discrete elements. The solution preferably consists in arranging step-up converters or step-down converters in a cascade-like or stack-like manner, said step-up converters or step-down converters being based on elementary components and regrouped in a suitable manner.

The use of combined resonant units enables the formation of efficient structures, wherein large voltage ratios can be achieved both for step-up converters as well as for step-down converters. The resonant units comprise, as is represented by way of example in figures 1 and 2, a resistance-like unit, an inductive-like unit and a capacitively-acting unit. It should be pointed out that it does not concern resistors, coils or capacitors in the conventional sense. The represented equivalent series resistance (ESR) r symbolises any kind of a dissipative process. The represented inductance symbolises all types of kinetic energy storage. The represented capacitance symbolises all types of static energy storage. The equivalent parallel resistance R represents any external load connected to the resonant circuit.

For example, the represented inductance is understood to be a conventional coil, a piezoelectric resonator, a dielectric resonator or a transmission line. In general, the technique according to the invention or the structure of a converter according to the invention should always be used when energy is to be converted in an efficient manner to carry out large impedance variations. In other words: in the electrical case the voltage ratio should be large in case of large load resistance variations.

For example, the invention thus also relates to electromechanical or mechanical devices or arrangements of such devices. In such a case, the inductance represents the inertia of the process. The capacitor stands in this connection for the potential energy that is stored for example in a string. The resistance r in this case stands for dissipative processes and R as the output energy extracted or to be extracted.

The present invention can be associated with conditions according to which energy mainly oscillates between the two energy storage forms. Insofar as use is made of only two storage devices which are complementary to each other, specific frequencies may be present for which the oscillation amplitude is maximised. In linear circuit frames, these frequencies are called natural resonant frequencies and correspond to a cancellation of the two equivalent reactance values. In such cases, the input impedance is resistive. The voltage ratio can be either greater than or less than 1 depending on the direction of the energy transmission. A step-up conversion corresponds to a series resonance, whereas a step-down conversion corresponds to a parallel resonance. Figures 1a to 2b correspondingly represent the four basic possibilities in respect of step-up and step-down converters.

As previously explained, the voltage ratio depends on the value of the equivalent load resistance R. In the case of a step-up converter, the voltage ratio tends at resonance towards the Q-factor of the resonator if the value of the resistance is very high. The voltage ratio falls if the resistance value diminishes. The efficiency decreases if the voltage ratio increases. Furthermore, the efficiency tends towards zero in the case of a voltage rise equal to Q-factor of the resonant circuit. If voltage ratio G is relatively small compared to the Q-factor of the resonator, the efficiency can be described with the following formula: *η* = 1/(1 + G/Q).

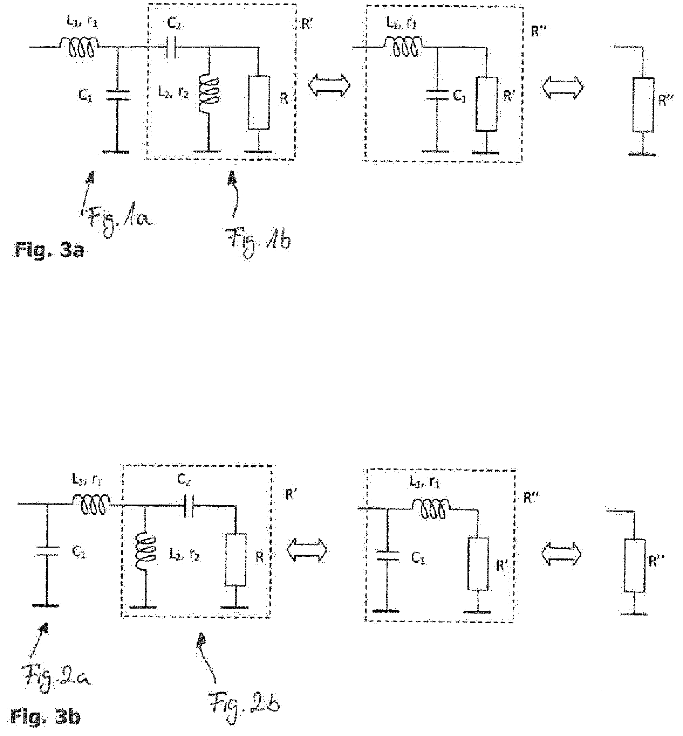

Furthermore, a general property exists in respect of coupled resonance circuits, which can be used to form simple configurations in respect of a converter according to the invention. Accordingly, the dissipation for a given output level is minimised in a permanent regime, if energy oscillations between adjacent circuits are minimised. For a series of pairs of complementary elements, the best constellation with regard to good efficiency is achieved when each complementary pair is matched at the same natural resonant frequency, so that an equivalent resistance is actually present with each transition of the resonating elements along the energy path. This general embodiment is represented in Fig. 3a and Fig. 3b. Fig. 3a represents a two-step up converter, whilst a two-step down converter is illustrated in Fig. 3b.

In order to obtain the same resonance for each step, the participating inductances and capacitances should lead to the same resonance frequency for all the resonant units. Namely: L₁C₁= L₂C₂ = ... = LₙCₙ.

The reactive elements can be inverted at each level, so that this leads to four possible embodiments in respect of a two-step up converter and moreover to four possible embodiments in respect of a two-step down converter.

A simple model, which is based on the best efficiency formula stated above, shows that the efficiency is increased with large total voltage ratios if a plurality of steps are performed instead of one step. When the voltage gain is much smaller than the Q-factor in every step, the optimum conditions are independent of the Q-factor. The optimum number of steps is then equal to the natural logarithm InG and the optimum voltage ratio for each step corresponds to the Euler number e = 2.7182. This leads to an optimum total voltage ratio of approx. 8 for two stages, of approx. 20 for three stages, of approx. 55 for four stages, of approx. 150 for five stages and so forth. Thus, if the expected voltage ratio is known, the correct number of stages or steps can be selected.

As already mentioned, it is particularly advantageous to arrange several identical components differently in the various stages of the converter. Moreover, it is possible for the inductive reactance units and/or the capacitor units each to be formed by a coil or a capacitor or a piezoelectric resonator or a dielectric resonator or a transmission line.

All the resonant units are preferably constituted such that the inductive reactance units and capacitor units of one resonant unit have reactance values very close or equal in amplitude and opposed in signs (jLω = 1/jCω or equivalently LCω² = 1).

Accordingly, it is possible to arrange several identical components differently in the various stages of the converter. The quality factor of such arrangements roughly corresponds to the quality factor for a single component. Due to the usage of identical components in different steps, identical inductive components and/or identical capacitive components can be regrouped into compact arrays. Therefore, it is easier to realise various implementations for different voltages and/or power in the manufacturing process. The size of the arrays determines the reactive power level of the array. It is possible for the components of the arrays to be connected in series or in parallel, so that the different stages are formed. Optionally, such arrays can be regrouped in standard casing formed very thin and flexible.

The converter preferably does not comprise a transformer. The converter is formed as AC-AC converter or as AC-DC converter or as DC-DC converter or as DC-AC converter. Particularly preferably, the converter is formed as a DC-AC converter or as a DC-DC converter. For example, a general AC-DC converter can be cast into a cascade made of a rectifier followed by a DC-DC converter.

If a very large direct voltage is to be generated from a small input voltage, a very large number of steps to be carried out would possibly have to be created. In such a case, a large number of piezoelectric resonators are required for two reasons. In the first place, a very large number of piezoelectric resonators must be used in order to fulfil the impedance tuning rules. Moreover, a large number of piezoelectric resonators are required in order to be able to withstand the high voltages in the last step of the converter.

It is possible for the converter to comprise a voltage multiplier, especially a diode multiplier, instead of a series arrangement of piezoelectric elements. The diode multiplier can be constituted as a final diode multiplier, which is integrated in the converter on the consumer side as it will produce a DC output voltage. The global stray capacitance of the diodes can be compensated by the piezoelectric inductance array. This produces a very high degree of efficiency for the voltage multiplier, even at very high voltage ratios, amounting for example to more than 10. Such an embodiment is extremely practical for low power applications, since the number of required piezoelectric resonators can be reduced to just a few units. For example, voltage ratios of 50 can be achieved by combining one first resonant step using three piezoelectric resonators in series providing a voltage ratio of five with a second step made of a tenfold diode multiplier. The following voltage steps are possible: 100 V -> 500 V -> 5 kV.

The structure of the converter according to the invention is extremely compact and has a low weight.

Four embodiments are possible in respect of the arrangement of the diode multipliers. The arrangement is governed according to the way in which the AC capacitors and DC capacitors sides are connected respectively to the AC input source and the voltage reference, which is usually the ground. These capacitors can be connected on both sides in series or in parallel.

Up converters, which are formed from standard coils and capacitors, suppress the harmonics of the input signal, since the impedance is minimised only at resonance. Down converters, which are formed from standard coils and capacitance, do not reject such harmonics, since in the case of a down converter the impedance is maximised at resonance and is much smaller for harmonics. For other applications or technologies, the behaviour in connection with the harmonics is dependent on the impedance behaviour at high frequencies.

The harmonics can be effectively damped with the aid of rejecting filters. Rejecting filters can be formed from the same components as the inductive reactance unit or the capacitor unit of the converter. If the rejecting filter does not influence the voltage ratio, it will not usually process the same reactive power level. Accordingly, a harmonic suppression circuit comprising a smaller number of components can be formed.

The converter can comprise a regulating unit formed on the signal generator side for regulating the input power according to the needs on the load side/consumer side, wherein the regulating unit preferably comprises an input current/voltage control and/or a pulse width modulation unit (PWM) and/or a burst modulation control.

Moreover, the converter can comprise a regulating unit formed on the consumer side for controlling the output voltage. The converter can accordingly comprise regulating units on the signal generator side as well as on the consumer side. An output voltage regulating unit and/or a safety control is preferably formed on the consumer side or rectification side.

The input voltage should be controlled, if the regulating unit is formed so as to generate equivalent constant load impedance before the load regulation circuit in order to maximize efficiency independently of the final power output P. This can take place directly by means of an input voltage control or by a pulse-width modulation unit or by a burst modulation control. The equivalent input voltage should be controlled according to the following formula: Vₗₙ = k*sqrt (P); k stands for a coefficient which is dependent on the voltage ratio.

In the case of the regulating unit formed on the signal generator side, use is particularly preferably made of an input voltage control or a burst modulation control. A burst mode may lead to a more diffused spectrum compared for example with a pulse width modulation control (a quasi-continuous aspect instead of peaks at fixed frequencies).

A burst modulation control can easily be implemented at high frequencies. If, for example, a frequency of 10 MHz is present, 100 successive periods with a total control time of 10 µs are sufficient to obtain a well filtered and controlled permanent output. The relatively low frequencies, which are induced by the regulation process, can be filtered after rectification by output capacitances. For burst of 10 µs the low frequency modulation will be in the 100 kHz range. Remaining voltage ripples will be easily filtered out by output capacitors of reasonable sizes.

Synchronous rectification and other general techniques and methods can be combined with the present invention. A synchronous rectification can easily be implemented, since the phase shift between the generator switching device and the rectifier switching device is given once for all according to the number of stages.

A further aspect of the invention concerns a power device, which comprises at least one converter according to the invention, wherein the converter is formed between the signal generator circuit and a consumer circuit.

The consumer circuit can comprise a rectifier circuit, especially a rectifier circuit and a load regulation and a DC current load.

The regulating unit for regulating the input current/signal can be an input voltage control and/or a pulse-width modulation unit (PWM) and/or a burst modulation control.

The invention will be explained in greater detail below using examples of embodiment and with the aid of figures.

In the figures:
- Fig. 3a: shows a two-step up converter;
- Fig. 3b: shows a two-step down converter;
- Fig. 4a: shows a two-step down converter;
- Fig. 4b: shows a two-step up converter;
- Fig. 5: shows a two-step up converter according to a further embodiment of the invention;
- Fig. 6: shows a complete two-step up system;
- Fig. 7: shows a complete two-step down system; and
- Fig. 8: shows a two-step up converter with a diode multiplier.

Figures 1a - 2b show, as already mentioned, four possibilities for obtaining a full resonant up conversion or a full resonant down conversion. These represented converters are based on basic resonator structures, wherein in the electric representations the represented coil L stands as a placeholder for the processing of kinetic energy, condenser C stands as a placeholder for the processing of potential energy. Moreover, resistors R and r are represented. Resistor r is connected to inductive element L and symbolises kinetic power losses. Potential losses are usually negligible. Resistor R, on the other hand, symbolises extracted energy.

Fig. 1a and Fig. 1b represent the two possible cases for up converters. Fig. 2a and Fig. 2b represent the two possible cases for down converters.

Fig. 3a and Fig. 3b represent circuits or situations in which all the intermediate impedance values are resistive. These circuits or situations are associated with the lowest dissipation levels, since energy is not allowed to oscillate in-between successive stages. The situations represented in Fig. 3a and Fig. 3b can occur only for specific values of the inductive reactance units and capacitor units.

Fig. 3a represents a two-step up converter 10, wherein a converter according to the embodiment of Fig. 1b follows a converter according to the embodiment of Fig. 1a.

A two-step down converter 10 is represented in Fig. 3b, wherein a converter according to the embodiment of Fig. 2b follows a converter according to the embodiment of Fig. 2a.

It is also possible for identically formed converters to be constituted following one another. The intermediate impedance values are resistive with the best tuning conditions. It applies approximately: L₁C₁ω² = L₂C₂ω². It is possible for slight deviations of this basic tuning to occur on account of losses, especially in connection with piezoresonators used. Piezoresonators have very sharp response behaviour around resonance.

Figures 3a and 3b show in each case the intermediate resistance property for the best performance by the represented box reduction process R -> R' -> R".

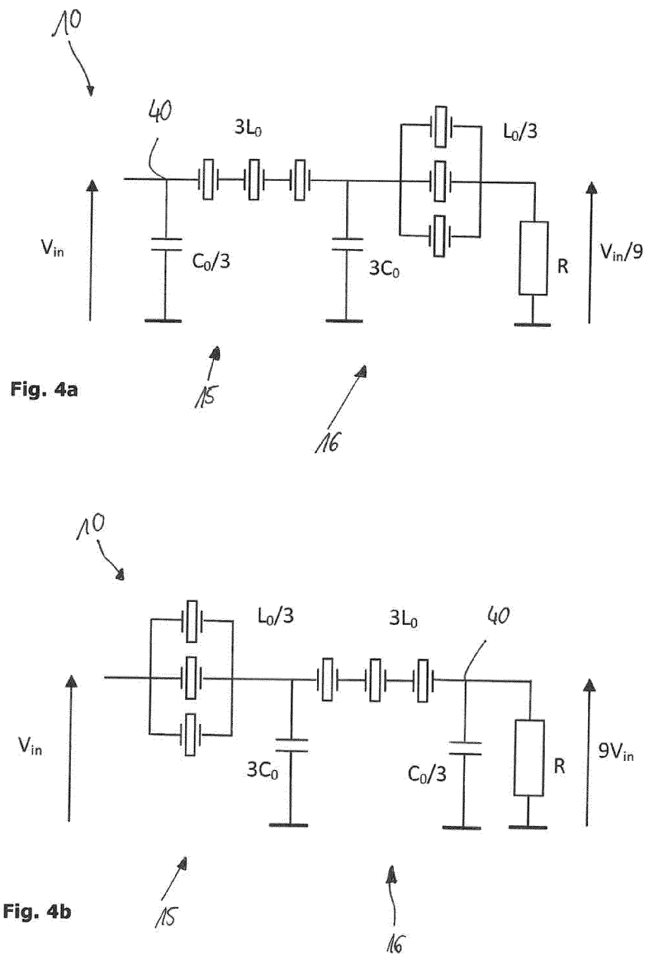

Figures 4a and 4b represent two-step converter 10, wherein the inductive reactance units comprise identical components. Converters 10 each comprise two resonant units 15, 16, which are formed from several inductive reactance units L₀ and in each case from a capacitor unit C₀.

The voltage amplification is approx. 3 (in Fig. 4a) and 1/3 (in Fig. 4b) for each individual step, wherein the total amplification amounts to approx. 9 (in Fig. 4a) and 1/9 (in Fig. 4b). All the impedances vary from one stage to the next at a value which corresponds to the square of the voltage ratio. Figures 4a and 4b represent piezoelectric elements instead of coils. This emphasises the fact that the inductive reactance units can be formed from all the elements available to the technology.

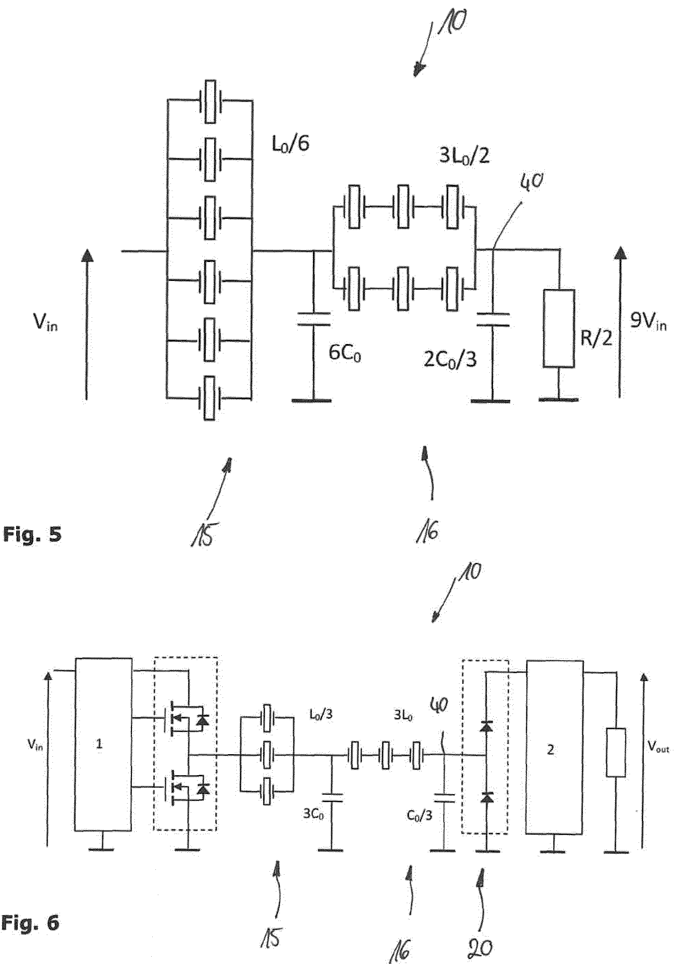

Fig. 5 shows a similar two-step up converter 10, as is represented in Fig. 4b. Converter 10 represented in Fig. 5, however, has a higher power capability, since the number of elements, i.e. the piezoelectric resonators, is doubled. Compared to the embodiment represented in Fig. 4b, the piezoelectric elements are doubled in each case and placed in parallel with the original piezoelectric elements.

A voltage ratio of 4, 9, 16, 25 can be achieved for the basic series/parallel matching of two, three, four, five elements. In such series parallel arrangements as represented in Fig. 5, the total reactive power level for the two stages 15, 16 is the same, if the reactance control requirements are met. Since the total power is equally spread in the inductive reactance units, the power level is also the same for all inductive reactance units.

For most embodiments of inductive reactance units, it is the case that an optimum value C₀ for the serial equivalent capacitance must be defined in connection with inductance value L₀, in order to achieve the best quality factor for the inductive reactance unit. The optimum C₀ value depends on one hand on the technology used and on the other hand on the selected resonance frequency and the reactive power level.

In the example represented in Fig. 5, the capacitance values can be obtained by similar series/parallel arrangements of reference value C₀. If the various groups of inductive reactance units do not have similar Q-factors or if the losses or temperature rise are larger in some places, it is possible to use a different number of components in successive steps 15, 16.

Fig. 6 represents an example of a complete two-step up converter 10. Box 1 symbolises regulating units, control devices and protection devices. A typical half-bridge switching device follows, which is formed with the aid of two MOSFET. The square wave signal then passes to a first resonant unit 15 and a second resonant unit 16. A half-bridge diode arrangement 20 is used to rectify the higher voltage. Box 2 follows, which for example symbolises a voltage regulation circuit. In order to achieve a high degree of efficiency, the regulating units (box 1 and box 2) should work in order that the equivalent resistance at node 40 depends slightly on the load consumption.

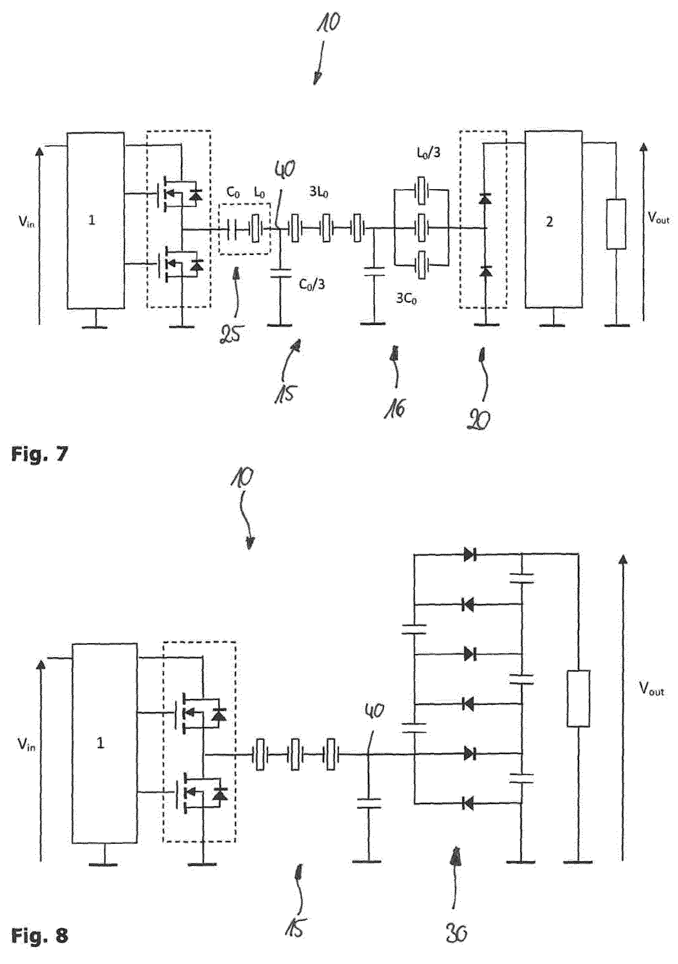

Fig. 7 represents a similarly formed two-step down converter 10. A rejection circuit 25 is formed between first resonant unit 15 and a signal generator which generates square wave signals. The aim of this circuit 25 is to suppress/reject harmonics. This rejection circuit 25 can be produced from a smaller number of components used in connection with resonant units 15 and 16. The selection regarding the number of components in connection with rejection circuit 25 depends on how efficiently harmonics have to be suppressed.

Fig. 8 represents a further converter 10, i.e. a two-step up converter 10. The latter comprises only one resonant unit 15, wherein a voltage multiplier 30 is formed in respect of the second stage. First resonant unit 15 comprises piezoelectric resonators arranged in series, wherein the second stage or voltage multiplier 30 is an x6 voltage multiplier (series-series type).

### LIST OF REFERENCE NUMBERS

- 10: converter
- 15: resonant unit
- 16: resonant unit
- 20: semiconductor diode arrangement
- 25: rejection circuit
- 30: voltage multiplier
- 40: node

## Claims

1. Converter (10), especially for use at high voltage ratios,
**characterized by**
a cascade of at least two steps, wherein at least the first step is made of a resonant unit (15), which comprises at least one inductive reactance unit and at least one capacitor unit, which are connected in series.

2. Converter (10) according to claim 1,
**characterized in that**
the second step is a rectification circuit or a voltage multiplier.

3. Converter (10) according to claim 1 or 2,
**characterized in that**
the second step is made of a resonant unit (16), which comprises at least one inductive reactance unit and at least one capacitor unit connected in series.

4. Converter (10) according to claim 3,
**characterized in that**
a high-level port of an elementary resonant unit (15, 16) is formed between a conductor and the common ground, wherein the conductor links the inductive reactance unit and the capacitor unit of the resonant unit (15, 16),
- wherein a low-level port is formed between the remaining open side of the elementary resonant unit (15, 16) and the ground, and
- wherein the at least two resonant units (15, 16) are connected in cascade through their input ports and output ports.

5. Converter (10) according to one of the preceding claims,
**characterized in that**
at least one resonant unit (15, 16) is made of an arrangement of identical components which are connected in series and/or in parallel.

6. Converter (10) according to one of the claims 3 to 5,
**characterized in that**
the inductive reactacne units and the capacitor units of the at least two resonant units are made of identical components which are arranged in different manners.

7. Converter (10) according to one of claims 3 to 6,
**characterized in that**
the at least two resonant units (15, 16) comprise the same number of components.

8. Converter (10) according to one of the preceding claims,
**characterized in that**
an inductive reactance unit and/or a capacitor unit is/are formed of a coil or a capacitor or a piezoelectric resonator or a dielectric resonator or a transmission line.

9. Converter (10) according to one of the preceding claims,
**characterized by**
a configuration as a DC-AC converter or DC-DC converter or AC-DC converter or AC-AC converter.

10. Converter (10) according to one of the preceding claims,
**characterized by**
a regulating unit (1) formed on the side of the signal generator, adapted to regulate the input current, wherein the regulating unit preferably comprises an input voltage control and/or a pulse-width modulation (PWM) unit and/or a burst modulation control.

11. Converter (10) according to one of the preceding claims,
**characterized by**
a regulating unit (2) formed on the side of the consumer, adapted to regulate the output voltage and/or adapted to maintain a constant equivalent resistance at a node (40) of the converter (10).

12. Converter (10) according to one of the preceding claims,
**characterized by**
a rejection circuit (25) formed on the side of the signal generator upstream of a first resonant unit (15).

13. Power device comprising at least one converter (10) according to one of claims 1 to 12, wherein the converter (10) is formed between a signal generator circuit and a consumer circuit.

14. Power device according to claim 13,
**characterized in that**
the consumer circuit comprises a rectifier circuit, especially a rectifier circuit and a load regulation (2) and a DC current load.

15. Power device according to claim 13 or 14,
**characterized by**
a regulating unit (1) for regulating the input signal, which is an input voltage control and/or a pulse-width modulation (PWM) unit and/or a burst modulation control.
